# EUROPEAN PATENT APPLICATION

(11) **EP 4 818 960 A1**
(43) Date of publication of application: **07.10.2026**
(21) Application number: 26150376.7
(22) Date of filing: 06.01.2026
(51) Int. Cl.: G06F 30/27

(54) **A GREEN HYDROGEN PRODUCTION ARTIFICIAL INTELLIGENCE (AI) ASSISTANT**

(30) Priority: 09.01.2025 IN 202511002046; 04.04.2025 US 202519170768
(71) Applicant: Schneider Electric Systems USA, Inc., Foxborough, MA 02035 (US)
(72) Inventor: SINHA, Bhaskar, 500019 Hyderabad (IN); GONDHI, Dinesh, Norwood, 02062 (US); KOTTANA, Venkateswara Rao, 531036 Visakhapatnam (IN); GOTTUMUKKALA, Srisuhasini, 500049 Hyderabad (IN); YADAV, Arvind, 123021 Haryana (IN); ZHANG, Ning, North Andover, 01845 (US)
(74) Representative: Openshaw & Co.

(57) **Abstract**

A green hydrogen production system uses an AI operator assistant. Electrolysis sensors collect operating conditions of an automated electrolysis system (102). An artificial intelligence (AI) electrolysis prediction engine (112) uses the operating conditions to model electrolysis. The AI electrolysis prediction engine (112) models electrolysis using a both first principles model (304) and machine learning models of one or more degradation factors, such as electrolyzer degradation or electro-osmatic drag. The AI electrolysis prediction engine (112) hybridizes the models to generate initial set point scenarios for the electrolysis process. An AI operator assistant receives process characteristics from the operator, which are used to select a set point scenario. An automation control processor (106) then controls electrolysis in accordance with the selected settings. An AI observer engine (114), an AI reasoning engine (116), and an AI error minimization engine (118) perform different aspects of a process to observe the process, determine deviations, and predict further optimization.

## Description

### BACKGROUND

Green H₂ (Hydrogen) production is the process of producing hydrogen for use in green energy solutions. Green hydrogen production struggles to compete with other conventional fuels due to the high cost of production. In some cases, production of green hydrogen can cost between $4-5 per kg. In producing green hydrogen, 70% of the operating expense relates to energy consumption. For green hydrogen to compete with other fuel sources, the cost to produce must be driven down.

Currently there is a lack of advanced frameworks that offer insights into the electrolysis process used during green hydrogen production. Conventional methods of performing electrolysis do not provide the deep level of analysis needed to drive the cost of production down. Even in scenarios where the entire process can be monitored, developing a framework to optimize production is a costly operation and requires substantial research time. Further, many different variables may cause a degradation within the system, causing the process to operate inefficiently and leading to a decrease in throughput. Modeling these potential degradations can be difficult because of the complexity of modeling and the substantial number of variables impacting each individual degradation. Additionally, due to the complexity in modeling and optimizing the electrolysis process, there can be significant downtime for the system, which leads to further inefficiency.

### SUMMARY

Aspects of the present disclosure provide a green hydrogen production artificial intelligence (AI) assistant. The AI assistant receives measurements from the electrolysis system and predicts initial set points for the system through a hybridized model. The hybridized model includes a first principles model of the electrolysis process as well as one more machine learning (ML) degradation factor models. By providing a hybridized model of the electrolysis process, the AI assistant more accurately predicts the electrolysis process based on environmental factors. Further operator input enables the AI assistant to provide recommended settings based on selected process characteristics.

In an aspect, a green hydrogen production system includes an automated electrolysis system configured to perform electrolysis in response to an input set point configuration and an automation control processor communicatively coupled to the automated electrolysis system. The automation control processor is configured to receive the input set point configuration and configure the automated electrolysis system with the input set point configuration. The system also includes one or more electrolysis monitoring sensors coupled to the automated electrolysis system. The electrolysis monitoring sensors measure one or more process indicators to generate electrolysis measurement information. The system further includes electrolysis prediction processing hardware coupled to the electrolysis monitoring sensors and a memory coupled to the electrolysis prediction processing hardware. The memory stores computer-executable instructions executed by the electrolysis prediction processing hardware to configure the green hydrogen production system for receiving, from the electrolysis monitoring sensors, the electrolysis measurement information and executing an artificial intelligence (AI) electrolysis prediction engine to predict one or more set point scenarios. Executing the AI electrolysis prediction engine includes generating, by a first principles model, one or more predicted set points based upon the received electrolysis measurement information and modeling, by one or more machine learning models, one or more predicted degradation factors based upon the received electrolysis measurement information. Executing the AI electrolysis prediction engine also includes generating the one or more predicted set point scenarios based upon the initial set points and the predicted degradation factors. The executed instructions further configure the green hydrogen production system for executing an AI operator assistant engine to determine selected set points. Executing the AI operator assistant engine includes predicting a selected set point configuration based upon weighting process characteristics received from an operator and the predicted set point scenarios. In addition, the executed instructions configure the green hydrogen system for transmitting the selected set point configuration to the automation control processor as the input set point configuration.

In another aspect, a method for producing green hydrogen includes collecting electrolysis measurement information from one or more electrolysis monitoring sensors of an automated electrolysis system and executing, by electrolysis prediction processing hardware, an artificial intelligence (AI) electrolysis prediction engine. Executing the AI electrolysis engine includes generating, by a first principles model, one or more initial set points based upon the electrolysis measurement information and modeling, by one or more machine learning models, one or more predicted degradation factors based upon the electrolysis measurement information. Executing the AI electrolysis engine further includes generating one or more predicted set point scenarios based upon the initial set points and the predicted degradation factors. The method further includes executing, by the electrolysis prediction processing hardware, an AI operator assistant engine. Executing the AI operator assistant engine includes predicting a selected set point configuration based upon weighting process characteristics received from an operator and the predicted set point scenarios. The method also includes performing, by the automated electrolysis system, an electrolysis process in accordance with the selected set point configuration.

In yet another aspect, a method of training an artificial intelligence (AI) electrolysis prediction engine includes collecting, from an automated electrolysis system, historical electrolysis process information, historical concentration information, and historical electrolysis measurement information. The method also includes training an electrolyzer degradation sensor machine learning model based upon the historical concentration information and historical electrolysis process information. The method further includes training an electro-osmatic drag machine learning model based upon the historical electrolysis measurement information and executing, by an electrolysis prediction processor, an AI error minimization engine to generate retraining information. Executing the AI error minimization engine includes retrieving electrolysis process information from an electrolysis process database and generating, by a machine learning model, retraining information based upon the electrolysis process information. In addition, the method includes retraining at least one of the electrolyzer degradation sensor machine learning model or the electro-osmatic drag machine learning model with the retraining information.

Other objects and features of the present invention will be in part apparent and in part pointed out herein.

### BRIEF DESCRIPTION OF THE DRAWINGS

FIG. 1 is a block diagram illustrating a system for producing green H₂ according to an embodiment.
FIG. 2 is a block diagram illustrating an example of an electrolysis system.
FIG. 3A is a flow diagram illustrating a digital twin hybrid model combining a first principles model and a machine learning model for optimizing an electrolysis system according to an embodiment.
FIG. 3B is a flow diagram illustrating a process of generating, through artificial intelligence (AI), a predicted set point configuration and executing electrolysis according to the configuration according to an embodiment.
FIG. 4 is a flow diagram illustrating a process of training an AI electrolysis prediction engine according to an embodiment.
FIG. 5 is a flow diagram illustrating a process of retraining an AI electrolysis prediction engine according to an embodiment.
FIG. 6 is a flow diagram illustrating a process of measuring electrolysis process degradation through a virtual sensor according to an embodiment.
FIG. 7 is a flow diagram illustrating a process of measuring impact on voltage due to deviation in electrolyte concentration according to an embodiment.
FIG. 8 is a flow diagram illustrating a machine learned model for a virtual sensor configured to determine electrolyte concentration according to an embodiment.
FIG. 9 is a flow diagram illustrating a process of modeling electro-osmatic drag through a hybrid machine learning model according to an embodiment.

Corresponding reference characters indicate corresponding parts throughout the drawings.

### DETAILED DESCRIPTION

The features and other details of the concepts, systems, and techniques sought to be protected herein will now be more particularly described. It will be understood that any specific embodiments described herein are shown by way of illustration and not as limitations of the disclosure and the concepts described herein. Features of the subject matter described herein can be employed in various embodiments without departing from the scope of the concepts sought to be protected.

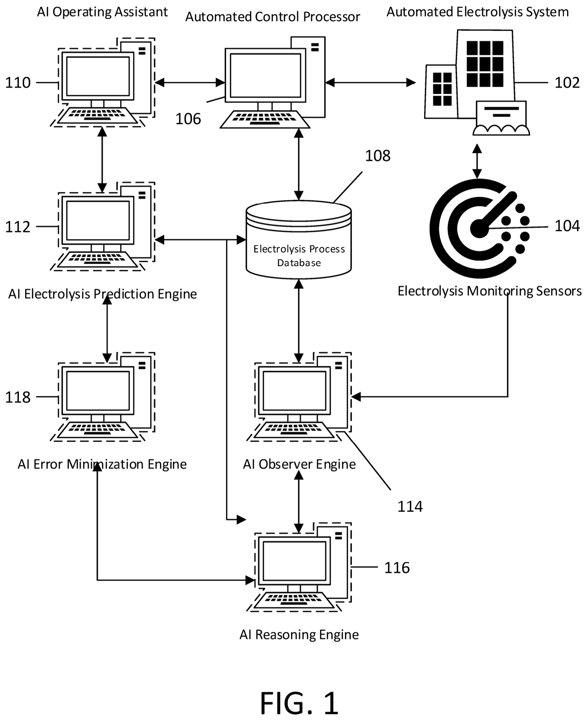

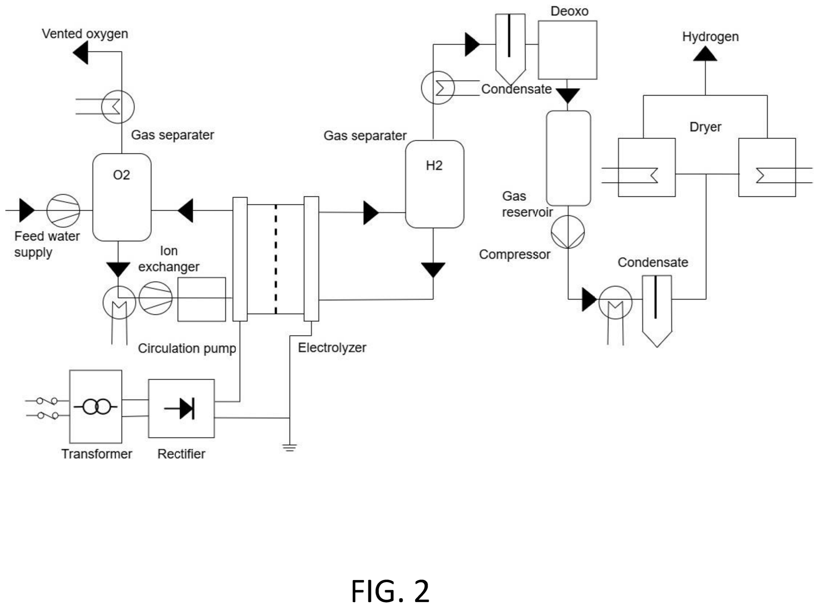

Referring to the figures and description below, a system for producing green H₂ (hydrogen) is disclosed. FIG. 1 is a block diagram illustrating the system. In some embodiments, the system configures and performs electrolysis through an automated electrolysis system 102. FIG. 2 is a block diagram illustrating one example of an electrolysis system which performs electrolysis within the automated electrolysis system. In some embodiments, the automated electrolysis system 102 performs electrolysis according to one of several methods such as anion exchange membrane electrolysis, proton exchange membrane electrolysis, alkaline electrolysis, or solid oxide electrolyzer cells. In some embodiments, the automated electrolysis system 102 includes hardware configured to perform electrolysis in accordance with input settings. In an embodiment, electrolysis monitoring sensors 104 monitor and measure the electrolysis process performed by the automated electrolysis system 102. The electrolysis monitoring sensors may include any number of sensors useful for measuring aspects of the electrolysis process such as temperature, pressure, electrolyte concentration, pH concentration, voltage, and current.

The automated electrolysis system 102 communicatively couples with an automated control processor 106. The automated control processor 106 configures the automated electrolysis system 102 and transmits instructions to the system 102 to modify the configuration of the electrolysis process. In some embodiments, the automated control processor 106 includes input devices such as a mouse and/or keyboard for use by an operator. In one embodiment, the automated control processor 106 connects to the electrolysis monitoring sensors 104 to retrieve sensor measurement information. In an embodiment, the automated control processor includes a display for showing configuration settings and sensor measurement information to an operator.

An electrolysis process database 108 receives and stores information related to the electrolysis process. In some embodiments, the electrolysis process database 108 connects with the automated control processor 106 to receive and store the measurement information captured by the electrolysis monitoring sensors 104, which has been transmitted through the automated electrolysis system 102. In an embodiment, the automated control processor 106 connects to the database 108 to retrieve measurement information regarding an ongoing electrolysis process. In another embodiment, the automated control processor 106 retrieves historical electrolysis information from the database 108 for displaying to an operator. In some embodiments, the database 108 resides on hardware within the electrolysis plant.

An artificial intelligence (AI) operator assistant 110 transmits predicted set point scenarios for the electrolysis process to the automated control processor 106, described further below. In one embodiment, the operating assistant 110 resides on different infrastructure than the automated control processor 106 within the electrolysis plant. In one embodiment, the AI operator assistant 110 further receives input settings from the automated control processor 106 to determine a selected set point configuration, described further below. In some embodiments, the automated control processor 106 performs a closed-loop operation where the processor 106 configures and performs electrolysis in accordance with the AI operator assistant 110 selected set point configuration without intervention by an operator. In another embodiment, an operator approves or rejects selected set point configuration provided by the AI operator assistant 110 before the automated control processor 106 configures and performs the electrolysis process.

In an embodiment, the AI operator assistant 110 communicates with an AI electrolysis prediction engine 112. The AI electrolysis prediction engine 112 connects through a network to the electrolysis process database 108 to retrieve historical electrolysis process information and sensor measurement information. In some embodiments, the AI electrolysis prediction engine 112 includes multiple models of the electrolysis process, described further below, to determine predicted set points. In one or more embodimeants, the AI electrolysis prediction engine 112 includes a machine learning (ML) model to determine initial set points. In some embodiments, the AI electrolysis prediction engine 112 hybridizes both one more first principles models with one or more ML models. By hybridizing both first principles models and ML models, the AI electrolysis prediction engine 112 more accurately determines set point configuration for electrolysis based on real world constraints. In an embodiment, the AI electrolysis prediction engine 112 operates on the same infrastructure as the AI operator assistant 110. In another embodiment, the AI electrolysis prediction engine operates on different infrastructure than either the AI operator assistant 110 or the automated control processor 106.

In one embodiment, an AI observer engine 114 monitors the electrolysis process performed by the automated electrolysis system 102. In some embodiments, the AI observer engine 114 receives sensor measurement information by connecting directly with the electrolysis monitoring sensors 104. In other embodiments, the AI observer engine 114 retrieves sensor measurement information by retrieving the information from the electrolysis process database 108. The AI observer engine 114 predicts the expected trend of the electrolysis process, described further below. Then the AI observer engine 114 compares the predicted process with actual measurements collected by the electrolysis monitoring sensors to determine performance trend differences.

In an embodiment, an AI reasoning engine 116 receives performance trend differences and models identified scenarios causing a deviation from the predicted trend. In some embodiments, the AI reasoning engine 116 operates on the same hardware as the AI observer engine 114. In other embodiments, the AI reasoning engine 116 operates on separate infrastructure within the electrolysis plant. The AI reasoning engine 116 receives the performance trend differences determined by the AI observer engine 114 to generate identified scenarios cause a deviation, further described below. In some embodiments, the AI reasoning engine 116 receives the selected set point configuration from the automated control processor 106 upon rejection of the configuration by the operator. The AI reasoning engine 116, may determine the reason for rejection to generate identified scenarios correcting for the rejection, described further below, to provide back to the operator for operator approval.

In one embodiment, an AI error minimization engine 118 retrains the AI electrolysis prediction engine 112 based upon the identified scenarios. In some embodiments, the AI error minimization engine 118 operates on the same hardware as the AI observer engine 114 and the AI reasoning engine 116. In other embodiments, the AI error minimization engine 118 operates on separate infrastructure within electrolysis plant. The AI error minimization engine 118, receives the identified scenarios causing the deviation generated by the AI reasoning engine 116 and updates the AI electrolysis prediction engine 112, described further below. In some embodiments, the AI error minimization engine 118 updates the weights of the models of the AI prediction engine 112. In one embodiment, the AI error minimization engine 118 generates data based on the identified scenarios causing the deviation, described further below, to feed into the AI electrolysis prediction engine to retrain one or more of the models.

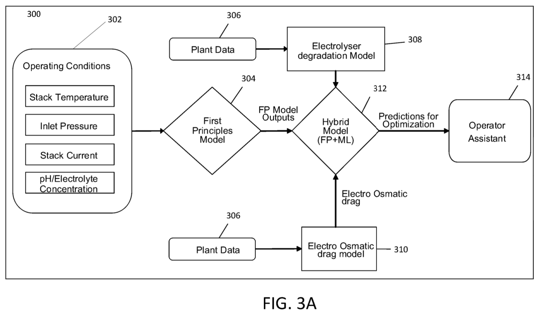

FIG. 3A is a flow diagram illustrating a digital twin hybrid model 300 combining a first principles model and a machine learning model for optimizing an electrolysis system according to an embodiment. The model receives operating conditions 302 measured by the electrolysis monitoring sensors 104. In some embodiments the operating conditions 302 include the stack temperatures, the inlet pressure, the stack current, and the pH/electrolyte concentration. Then a first principles model 304, models the electrolysis process. A conventional first principles model examines an overall cell over-potential, Vcell = Vocv + Vohmic + Vact + Vmt, where:
Vcell = Overall cell over potential
Vocv = Open circuit voltage
Vohmic = Ohmic over potential
Vact = Activation over potential
Vmt = mass transport over potential

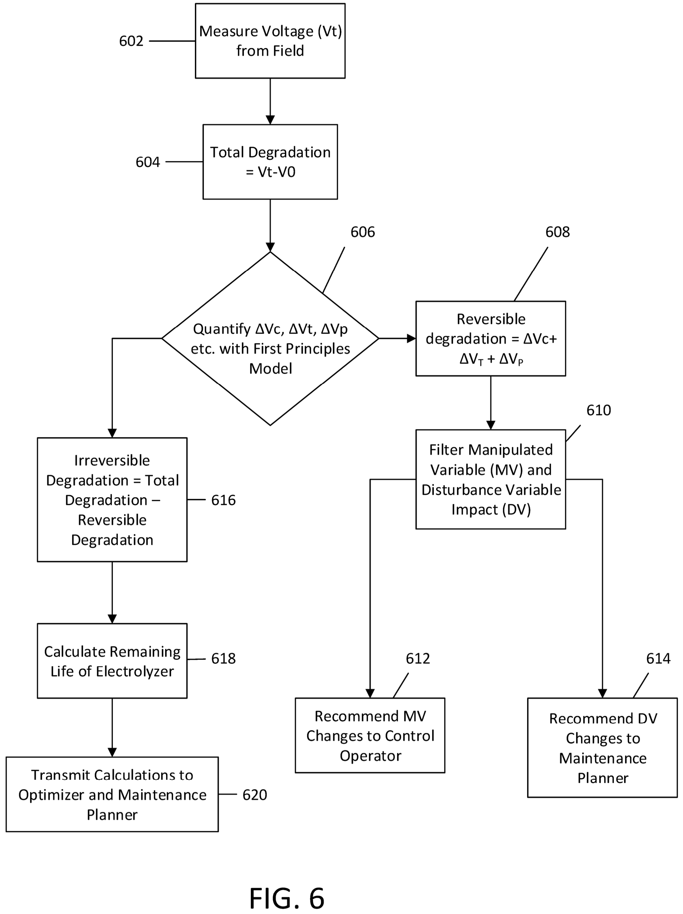

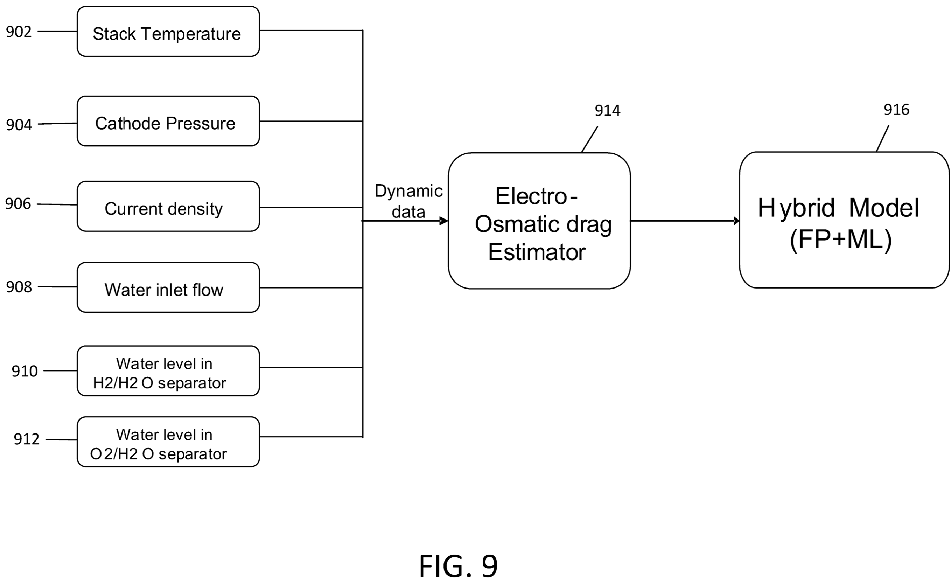

Plant data 306 also collected by the electrolysis monitoring sensors 104 feeds into one more machine learning models to predict degradation within the process. In one embodiment, the machine learning models include an electrolyzer degradation model 308, see FIG. 6 described further below, and an electro-osmatic drag model 310, see FIG. 9 described further below. The hybrid model 312 combines the predictions generated by the first principles model and the machine learning model to predict set points for the electrolysis process. The AI operator assistant 110, 314 receives the predicted set points to present to an operator or to further incorporate with the process characteristics to predict an optimal set point configuration.

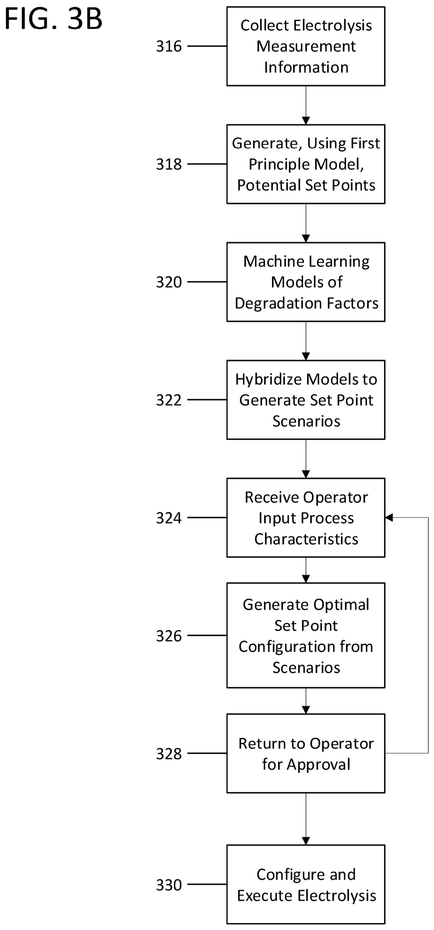

FIG. 3B is a flow diagram illustrating an embodiment for a process of generating predicted set points and configuring the automated electrolysis system 102 to execute electrolysis using the digital twin hybrid model 300. In some embodiments the electrolysis prediction engine 112 includes the digital twin hybrid model 300. At step 316, the initial state of the automated electrolysis system 102 is measured. The electrolysis monitoring sensors 104 collect measurement information from the system 102. In some embodiments, the measurement information includes a combination of stack temperature, inlet pressure, stack current, electrolyte concentration, or pH concentration. The sensors 104 then may transmit the information to the electrolysis process database 108 or to the automated control processor 106 directly.

Next at step 318, the automated control processor 106 transmits the measurement information to the AI operator assistant 110 and/or the AI electrolysis prediction engine 112 to generate initial set points based upon a first principles model. In some embodiments, the AI electrolysis prediction engine 112 generates initial set points by executing a set of physics-based equations, which underlie the first principles model. In one or more embodiments, the first principles model 304 receives operating conditions 302 including stack temperature, inlet pressure, stack current, and pH/electrolyte concentration as an input to the first principles model. In an embodiment, each of the input variables is given the same weight in modeling electrolysis. In other embodiments, the variables may be weighted depending on their impact on the electrolysis process. In some embodiments, the AI electrolysis prediction engine 112 generates multiple optimal set point configurations based on different potential process characteristics. Potential process characteristics may include optimizing the set points to maximize the electrolyzer life time or maximizing process efficiency.

Then at step 320, the AI electrolysis prediction engine 112 models one or more electrolysis degradation factors of the electrolysis process. In one or more embodiments, the electrolysis degradation factors are modeled by a machine learning model. Due to the changing nature of the electrolysis environment, many sources of degradation may impact efficiency, such factors include metal deposits on the cathode, membrane porosity, and membrane damage. In some embodiments, the AI electrolysis prediction engine 112 models electrolyzer degradation 308, described further below. In some embodiments, the AI electrolysis prediction engine 112 models electro-osmatic drag 310, described further below. In other embodiments, the AI electrolysis prediction engine 112 models other degradation factors impacting the electrolysis process. The electrolysis degradation factors enabled the AI electrolysis prediction engine 112 to accurately predict degradation caused by the process environment such as changes to electrolyte concentration.

The AI electrolysis prediction engine 112 then hybridizes the first principles model and the ML electrolysis degradation models at step 322 as shown in, for example, FIG. 3A. In some embodiments, the AI electrolysis prediction engine 112 generates multiple predicted set point scenarios by taking the first principles model initial set point configurations and weighting them with the predicted degradation. By hybridizing the models, the AI electrolysis prediction engine 112 better predicts real world electrolysis scenarios and set points by incorporating impacts caused by the real world physical environment. As a result, the model provides more accurate predictions of set point configurations for execution for a particular set of process characteristics.

Then the AI operator assistant 110 receives an input from the operator indicating one or more desired process characteristics at step 324. As described above, the process characteristics indicate preferences for performing electrolysis for a desired outcome such as maximizing electrolyzer lifetime or maximizing energy efficiency. An operator may input the process characteristics through the automated control processor 106 or directly into the AI operator assistant 110. In some embodiments, the process characteristics comprise multiple settings for which the operator seeks optimization. For example, an operator may input settings that indicate a preference to balance between maximizing electrolysis efficiency and electrolyzer lifetime.

Next at 326, the AI operator assistant 110 generates an optimal set point configuration based on the predicted set point configurations from the electrolysis prediction engine 112 and the operator input process characteristics. In some embodiments, the AI operator assistant 110 models electrolysis based on the predicted set point configurations and the input process characteristics. For example, if an operator seeks to maximize energy efficiency, the AI operator assistant 110 may select an optimal set point configuration from the generated predicted set points based on the configuration that requires the least energy consumption to meet the required hydrogen productivity. As a result, the AI operator assistant 110 presents a selected set point configuration that best matches the objectives of the operator input characteristics.

In some embodiments, the AI operator assistant 110 or the automated process controller 106 provides the selected set point configuration to an operator at step 328. In some embodiments, the AI operator assistant 110 or the automated process controller 106 shows the selected set point configuration on a display connected to the assistant 110 or controller 106. The operator then may determine whether the selected set point configuration should be applied to the system and electrolysis executed with those settings. In one embodiment, if the operator rejects the selected set point configuration, the selected set point configuration is transmitted to the AI reasoning engine 116 for analysis, described further below. In some embodiments, the operator alters settings in the automated process controller 106 and the automated process controller 106 transmits the altered settings to the AI reasoning engine 116 before executing the electrolysis process. In yet another embodiment, the process returns to step 324 to allow the operator to select a different set of process characteristics, such as optimizing for electrolyzer lifetime, and generating a new optimal set point configuration.

Then at step 330, the automated process controller 106 configures the automated electrolysis system 102 with the approved set point configuration. In an embodiment, the system performs closed-loop execution of electrolysis. As a result, the automated process controller 106 automatically applies the selected set point configuration to the automated electrolysis system 102 and executes electrolysis in accordance with those settings without review by an operator. By performing closed-loop execution, the system may perform operations to start or manage an ongoing electrolysis process in situations where response time is critical to the operation. Further, performing closed-loop execution minimizes downtime and increases the efficiency of the electrolysis process.

In some embodiments, the AI operator assistant 110 generates recommendations for optimizing electrolysis throughout execution of the process. In an embodiment, the AI operator assistant 110 generates recommendations on a set cadence, such as every hour. A regular cadence ensures that execution of the electrolysis process accounts for degradation and changes in efficiency due to interaction between operating variables. In other embodiments, the AI operator assistant 110 generates recommendations in response to an event, such as an increase or decrease in power demand or a change in production demand. Responsive recommendations ensure that the electrolysis process updates in accordance with substantial changes in demand or the environment. After generating a recommendation, the AI operator assistant 110 transmits the generated set point configuration to the automated process controller 106 for approval by an operator. In some embodiments, the automated process controller 106 implements the configuration changes without operator approval for an efficient closed-loop system.

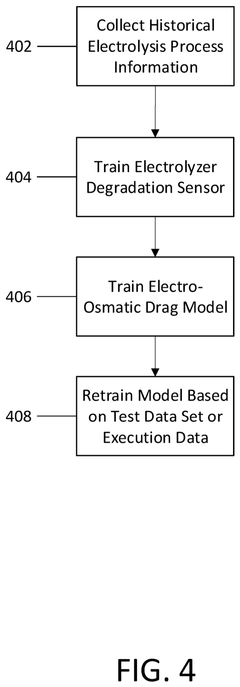

FIG. 4 is a flow diagram illustrating an example process of training the machine learning models of AI electrolysis prediction engine 112. At step 402, historical electrolysis process information is collected from the electrolysis process database 108. In some embodiments, the historical electrolysis process information includes set point configurations for an executed process, initial electrolysis monitoring sensor 104 measurements, measurements captured by the sensors 104 throughout the electrolysis process, output measurements of the produced hydrogen, and post process measurements such as electrolyzer concentration.

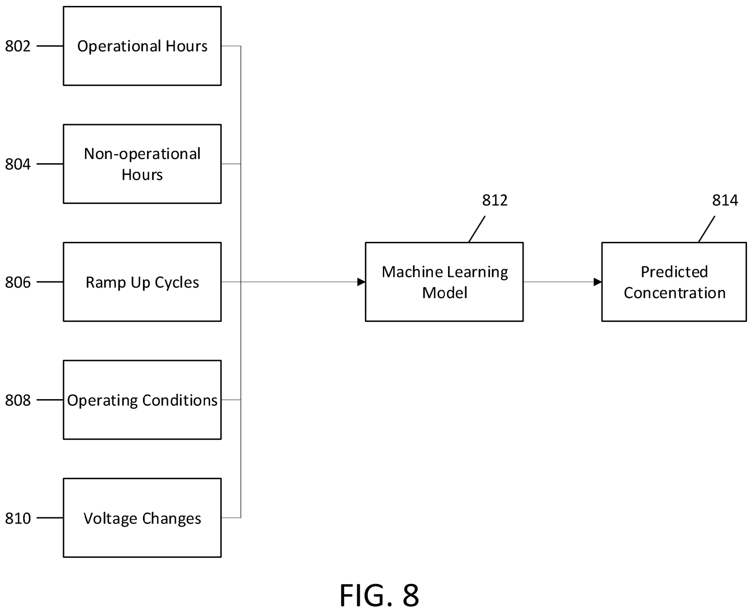

At step 404, an electrolyzer degradation sensor is trained. An electrolyzer degradation sensor determines the reversible degradation caused by electrolyzer concentration. FIG. 6, described further below, illustrates an example of determining the electrolyzer degradation. In some embodiments, the electrolyzer degradation sensor determines the reversible degradation based upon a measured concentration of electrolyte. In other embodiments, a virtual concentration sensor, illustrated in FIG. 8 and further described below, predicts the concentration of electrolyte, which the electrolyte degradation sensor implements to determine the degradation. Thus, the degradation caused by the electrolyzer concentration determined without a direct measurement of the concentration.

An electro-osmatic drag model is trained at step 406. In some embodiments, the electro-osmatic drag model is a machine learning model. FIG. 9, further described below, illustrates an example of modelling the electro-osmatic drag. By using a ML model to train the electro-osmatic drag, the drag can be more accurately predicted than using a first principles model. First principles models struggle to model the electro-osmatic drag because of the complexity of the calculation and impact of numerous variables. Further, use of the electro-osmatic drag model can help determine if the membrane of the electrolysis system requires more hydration.

Next at step 408, the machine learning models retrain on a test data set and/or execution data. In one embodiment, training the model includes generating a test data set from the historical electrolysis process information. The test data set then can be fed back into the model for retraining. In one embodiment, the model retrains on measurement information collected during execution of the electrolysis process. In an embodiment, the AI error minimization engine 118 retrains the model based on measurement information by generating retraining information, described further below. In yet another embodiment, the model retrains on configuration settings input by an operator after rejection of a recommended configuration.

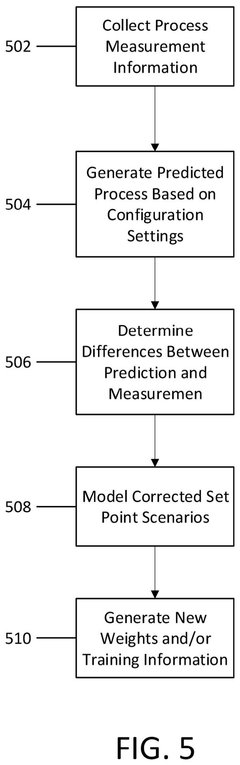

FIG. 5 is a flow diagram illustrating an example process of monitoring electrolysis execution and generating new weights for the models of the AI electrolysis prediction engine 112 or training information to further retrain the models. At step 502, the AI observer engine 114 collects process measurement information. The process measurement information includes measurements collected by the electrolysis monitoring sensors 104. In some embodiments, the electrolysis monitoring sensors 104 transmit the measurements directly to the AI observer engine 114.

At step 504, the AI observer engine 114 models a predicted execution of the process. The AI observer engine 114 generates a prediction using an AI model based upon the initial sensor measurement information and the selected set point configuration. In some embodiments, the AI model is a machine learning model. In some embodiments, the AI observer engine 114 predicts expected measurements throughout the execution of the electrolysis process which correspond to electrolysis monitoring sensor 104 measurements. The persistent monitoring by the AI observer engine 114 also increases safety for the system. Because the AI observer engine 114 continuously monitors the sensor measurement information, the system can react to changes impacting safety of the operation quickly if the measurements deviate from the expected performance.

Next the AI observer engine 114 compares the predicted measurement values with the actual measurement values collected by the electrolysis monitoring sensors 104 at step 506. In one embodiment, calculating the deviation from the predicted measurements also includes determining the frequency of the deviations. In some embodiments, the predicted measurement values and the actual measurement values are transmitted to the AI reasoning engine 116 to determine the performance trend differences. Then at 508 the AI reasoning engine 116 models identified scenarios causing the performance trend differences. In some embodiments, the AI reasoning engine comprises a machine learning model. The AI reasoning engine 116 generates updated set point scenarios to identify scenarios causing the deviation based on the selected set point configuration and the performance trend differences. In some embodiments, identifying the scenarios is further based on the operator input of the process characteristics. In another embodiment, the identified scenarios are further based upon the most recent measurement information collected by the sensors 104. By determining the identified scenarios causing a deviation from the prediction, execution of the electrolysis process can be updated with the identified scenarios to ensure the operation conforms with the input process characteristics.

The AI error minimization engine 118 updates the weights of the AI electrolysis prediction engine 112 and/or generates training information for the AI electrolysis prediction engine 112 at step 510. The AI error minimization engine 118 performs operations to support retraining of the AI electrolysis prediction engine 112. In some embodiments, the AI error minimization engine 118 generates training information to feed back into the AI electrolysis prediction engine 112 to further train the models. In an embodiment, the error minimization engine 118 generates the training information based upon the identified scenarios. In other embodiments, the error minimization engine 118 generates the training information based upon the identified scenarios and the measurement information collected during execution of the electrolysis process.

In one embodiment, the AI reasoning engine 116 and the AI error minimization engine 118 retrain the AI electrolysis prediction engine 112 in response to a rejection of a set point configuration by an operator. As described in FIG. 3B at step 314, an operator reviews the selected set point configuration suggested by the AI operator assistant 110. If the operator rejects the selected set point configuration, in some embodiments, the automated process controller 106 transmits the rejection, the initial sensor measurement information, the selected set point scenario, and the process characteristics to the AI reasoning engine 116. In some embodiments, the AI reasoning engine 116 the models one or more updated set points based on the information transmitted from the controller 106 and then identifies scenarios causing the deviation. In an embodiment, the AI error minimization engine 118 then updates the models of the AI electrolysis prediction engine 110 based on the identified scenarios. In some embodiments, the AI error minimization engine 118 generates a set of training information to retrain the AI electrolysis prediction engine 110 based on the identified scenarios. In another embodiment, an operator alters the configuration recommended by the AI operator assistant 110 and the changed settings are transmitted to the AI reasoning engine 116. Then the AI reasoning engine 118 models based on the input settings to identify scenarios that account for the changed settings. The AI reasoning engine then transmits the identified scenarios to the AI error minimization engine 118 for retraining of the AI electrolysis prediction engine 110.

FIG. 6 is a flow diagram illustrating a process of measuring electrolysis process degradation through a virtual sensor according to an embodiment. In some embodiments, a virtual sensor provides a virtual measurement of the degradation of the electrolyzer. As a result, the degradation can be incorporated by the AI electrolysis prediction engine with the first principles model to more accurately predict the initial set points for the current status of the automated electrolysis system 102. First at step 602, the present voltage (Vₜ) is measured. Then at step 604, the total degradation is determined by finding the difference between the present voltage and the initial voltage at the start of the life for the electrolysis system (V₀).

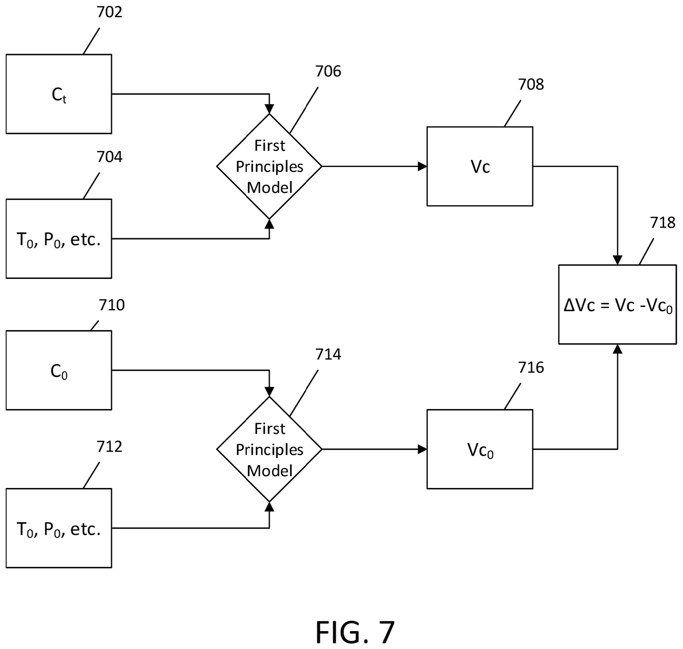

Next at step 606, the causes and proportions of the voltage increase are determined. Voltage in may increase due to electrolyte concentration deviation from the design concentration (ΔV_{C}), operating temperature deviation from the design temperature (ΔV_{T}), and/or changes in operating pressure from the design (ΔV_{P}). In some embodiments, a first principles model is used to determine the causes of the voltage increases and proportion associated which each cause. FIG. 7 is a flow diagram illustrating an example of calculating the degradation related to concentration deviation, further described below. Because the pressure, temperature, and concentration of the system can be changed within the system, degradation caused by an increase in voltage from these sources is reversible. As a result, the reversible degradation may be calculated through adding the total of the different reversible causes together, as shown at step 608.

After determining the reversible degradation, the degradation is filtered into two categories at step 610. Degradation caused by a variable under the control of the controller represents a manipulated variable, while degradation caused by a variable outside the control of the controller represents a disturbance variable. Next at 612, changes are recommended to update the system to reduce the reversible degradation related to the manipulated variables. Similarly, at 614, recommended changes are sent to the maintenance planner to reduce reversible degradation related to the disturbance variables.

At step 616, the irreversible degradation is calculated. The irreversible degradation can be determined by subtracting the reversible degradation from the total degradation. After the determining the irreversible degradation, the remaining life of the electrolyzer may be calculated at step 618. Further, the calculated irreversible degradation may be sent to the optimizer and maintenance planner for review at step 620. By calculating the reversible and irreversible degradation, the system can be optimized to correct for reversible degradation providing a more efficient electrolysis system.

FIG. 7 is a flow diagram illustrating a process of measuring electrolyte concentration deviation according to an embodiment. The present concentration of electrolyte (Ct) 702 and the design values of the other variables 704 adjusted for the current production rate are modeled using a first principles model 706 to generate a voltage for the present concentration (Vc) 708. In some embodiments, the present concentration is predicted by a virtual concentration sensor, see FIG. 8 described below. The design concentration of electrolyte (C₀) 710 is modeled using a first principles model 714 with the design values of the other variables 712 to generate a voltage for the design concentration (Vc₀) 716. In some embodiments, the other variables 704, 712 include the design temperature (T₀) and the design pressure (P₀). The voltage increase due to the deviation from the design concentration (ΔVc) 718 is calculated by taking the difference between Vc 708 and Vc₀ 716.

FIG. 8 is a flow diagram illustrating a machine learned model for a virtual sensor configured to determine electrolyte concentration according to an embodiment. In some embodiments, the virtual concentration takes in several operation measurements to predict the concentration of electrolyte. In an embodiment, the operation measurements include operational hours of the electrolysis system 802, non-operational hours of the electrolysis system 804, ramp up cycles 806, operating conditions 808, and measurement of voltage changes 810. In some embodiments, the operating conditions 808 include temperature and pressure. In one embodiment, the measurement of voltage changes 810 includes the change voltage resulting from the difference between the voltage before an electrolyte refill and after an electrolyte refill. In some embodiments, the measurement of voltage changes includes the change after each of several electrolyte refills. In an embodiment, the virtual concentration sensor is a machine learning 812 model taking in the operation measurements as input. The virtual sensor then predicts a concentration of electrolyte 814 which may be used by the electrolyzer degradation sensor or the AI electrolysis prediction engine, described above.

Referring now to FIG. 9, electro-osmatic drag significantly affects the efficiency of an electrolyzer. Modeling electro-osmatic drag using first principles is challenging due to its complexity. However, employing a machine learning model according to aspects of the present disclosure is beneficial for predicting electro-osmatic drag. The electro-osmatic drag model takes in real-time measurements of the electrolysis system to perform modeling. In one embodiment, the model receives the stack temperature 902, the cathode pressure 904, the current density 906, the water inlet flow 908, the water level in the H₂/H₂0 separator 910, and the water level in the O₂/H₂O separator 912. The electro-osmatic drag estimator 914, then models the electro-osmatic drag by weighting the various real-time measurements to predict the real world electro-osmatic drag. The hybrid model 916 then integrates the predicted electro-osmatic drag into the generate the predicted set point scenarios.

Embodiments of the present disclosure may comprise a special purpose computer including a variety of computer hardware, as described in greater detail herein.

For purposes of illustration, programs and other executable program components may be shown as discrete blocks. It is recognized, however, that such programs and components reside at various times in different storage components of a computing device, and are executed by a data processor(s) of the device.

Although described in connection with an example computing system environment, embodiments of the aspects of the invention are operational with other special purpose computing system environments or configurations. The computing system environment is not intended to suggest any limitation as to the scope of use or functionality of any aspect of the invention. Moreover, the computing system environment should not be interpreted as having any dependency or requirement relating to any one or combination of components illustrated in the example operating environment. Examples of computing systems, environments, and/or configurations that may be suitable for use with aspects of the invention include, but are not limited to, personal computers, server computers, hand-held or laptop devices, multiprocessor systems, microprocessor-based systems, set top boxes, programmable consumer electronics, mobile telephones, network PCs, minicomputers, mainframe computers, distributed computing environments that include any of the above systems or devices, and the like.

Embodiments of the aspects of the present disclosure may be described in the general context of data and/or processor-executable instructions, such as program modules, stored one or more tangible, non-transitory storage media and executed by one or more processors or other devices. Generally, program modules include, but are not limited to, routines, programs, objects, components, and data structures that perform particular tasks or implement particular abstract data types. Aspects of the present disclosure may also be practiced in distributed computing environments where tasks are performed by remote processing devices that are linked through a communications network. In a distributed computing environment, program modules may be located in both local and remote storage media including memory storage devices.

In operation, processors, computers and/or servers may execute the processor-executable instructions (e.g., software, firmware, and/or hardware) such as those illustrated herein to implement aspects of the invention.

Embodiments may be implemented with processor-executable instructions. The processor-executable instructions may be organized into one or more processor-executable components or modules on a tangible processor readable storage medium. Also, embodiments may be implemented with any number and organization of such components or modules. For example, aspects of the present disclosure are not limited to the specific processor-executable instructions or the specific components or modules illustrated in the figures and described herein. Other embodiments may include different processor-executable instructions or components having more or less functionality than illustrated and described herein.

The order of execution or performance of the operations in accordance with aspects of the present disclosure illustrated and described herein is not essential, unless otherwise specified. That is, the operations may be performed in any order, unless otherwise specified, and embodiments may include additional or fewer operations than those disclosed herein. For example, it is contemplated that executing or performing a particular operation before, contemporaneously with, or after another operation is within the scope of the invention.

When introducing elements of the invention or embodiments thereof, the articles "a," "an," "the," and "said" are intended to mean that there are one or more of the elements. The terms "comprising," "including," and "having" are intended to be inclusive and mean that there may be additional elements other than the listed elements.

Not all of the depicted components illustrated or described may be required. In addition, some implementations and embodiments may include additional components. Variations in the arrangement and type of the components may be made without departing from the scope of the claims as set forth herein. Additional, different or fewer components may be provided and components may be combined. Alternatively, or in addition, a component may be implemented by several components.

The above description illustrates embodiments by way of example and not by way of limitation. This description enables one skilled in the art to make and use aspects of the invention, and describes several embodiments, adaptations, variations, alternatives and uses of the aspects of the invention, including what is presently believed to be the best mode of carrying out the aspects of the invention. Additionally, it is to be understood that the aspects of the invention are not limited in its application to the details of construction and the arrangement of components set forth in the following description or illustrated in the drawings. The aspects of the invention are capable of other embodiments and of being practiced or carried out in various ways. Also, it will be understood that the phraseology and terminology used herein is for the purpose of description and should not be regarded as limiting.

It will be apparent that modifications and variations are possible without departing from the scope of the invention defined in the appended claims. As various changes could be made in the above constructions and methods without departing from the scope of the invention, it is intended that all matter contained in the above description and shown in the accompanying drawings shall be interpreted as illustrative and not in a limiting sense.

In view of the above, it will be seen that several advantages of the aspects of the invention are achieved and other advantageous results attained.

The Abstract and Summary are provided to help the reader quickly ascertain the nature of the technical disclosure. They are submitted with the understanding that they will not be used to interpret or limit the scope or meaning of the claims. The Summary is provided to introduce a selection of concepts in simplified form that are further described in the Detailed Description. The Summary is not intended to identify key features or essential features of the claimed subject matter, nor is it intended to be used as an aid in determining the claimed subject matter.

Further aspects of the invention are provided by the subject matter of the following clauses:
Clause 1. A green hydrogen production system comprising:
   an automated electrolysis system configured to perform electrolysis in response to an input set point configuration;
   an automation control processor communicatively coupled to the automated electrolysis system, the automation control processor configured to receive the input set point configuration and configure the automated electrolysis system with the input set point configuration;
   one or more electrolysis monitoring sensors coupled to the automated electrolysis system, the electrolysis monitoring sensors measuring one or more process indicators to generate electrolysis measurement information;
   electrolysis prediction processing hardware coupled to the electrolysis monitoring sensors;
   a memory coupled to the electrolysis prediction processing hardware, the memory storing computer-executable instructions that, when executed by the electrolysis prediction processing hardware, configure the green hydrogen production system for:
      receiving, from the electrolysis monitoring sensors, the electrolysis measurement information;
      executing an artificial intelligence (AI) electrolysis prediction engine to predict one or more set point scenarios, wherein executing the AI electrolysis prediction engine comprises:
         generating, by a first principles model, one or more initial set points based upon the received electrolysis measurement information;
         modeling, by one or more machine learning models, one or more predicted degradation factors based upon the received electrolysis measurement information; and
         generating the one or more predicted set point scenarios based upon the initial set points and the predicted degradation factors;
      executing an AI operator assistant engine to determine selected set points, wherein executing the AI operator assistant engine comprises:
         predicting a selected set point configuration based upon weighting process characteristics received from an operator and the predicted set point scenarios; and
   transmitting the selected set point configuration to the automation control processor as the input set point configuration.
Clause 1. The system of Clause 1, wherein the memory stores computer-executable instructions that, when executed by the electrolysis prediction processing hardware, further configure the green hydrogen production system for:
   executing, after transmitting the selected set point configuration, an AI observer engine to determine one or more performance trend differences, wherein executing the AI observer engine comprises:
      modeling a predicted electrolysis process based upon the electrolysis measurement information and the selected set point configuration;
      receiving process measurement information from the electrolysis measurement sensors, wherein the electrolysis measurement sensors are further configured to measure the process indicators during execution of an electrolysis process for generating the process measurement information; and
      determining the performance trend differences based upon the predicted electrolysis process and the process measurement information;
   executing an AI reasoning engine to predict identify scenarios causing the performance trend differences, wherein executing the AI observer engine comprises:
      modeling one or more updated set point scenarios based upon the performance trend differences and the electrolysis measurement information to generate identified scenarios causing the performance trend differences; and
   executing an AI error minimization engine to generate retraining information, wherein executing the AI error minimization engine comprises:
      generating retraining information based upon identified scenarios; and
      training the AI electrolysis prediction engine with the retraining information.
Clause 3. The system of Clause 1, wherein each of the process indicators comprises at least one of a stack current measurement, an electrolyte concentration measurement, a stack temperature measurement, or an inlet pressure measurement.
Clause 4. The system of Clause 1, wherein the automated electrolysis system is configured to perform electrolysis using one of the group of anion exchange membrane electrolysis, proton exchange membrane electrolysis, alkaline electrolysis, and solid oxide electrolyzer cells.
Clause 5. The system of Clause 1, further comprising a memory coupled to the automation control processor, the memory coupled to the automation control processor storing computer-executable instructions that, when executed by the electrolysis prediction processing hardware, configure the green hydrogen production system for:
   receiving the selected set point configuration;
   transmitting, to a display coupled to the automation control processor, the selected set point configuration;
   receiving, from an input device, a configuration status and a configuration rejection reasoning;
   transmitting, in response to the configuration status indicating rejection of the selected set point configuration, the configuration rejection reasoning to the AI reasoning engine; and
   executing, in response to the configuration status indicating acceptance of the selected set point configuration, an electrolysis process on the automated electrolysis system in accordance with the selected set point configuration.
Clause 6. A method for producing green hydrogen, the method comprising:
   collecting electrolysis measurement information from one or more electrolysis monitoring sensors of an automated electrolysis system;
   executing, by electrolysis prediction processing hardware, an artificial intelligence (AI) electrolysis prediction engine, wherein executing the AI electrolysis engine comprises:
      generating, by a first principles model, one or more initial set points based upon the electrolysis measurement information;
      modeling, by one or more machine learning models, one or more predicted degradation factors based upon the electrolysis measurement information; and
      generating one or more predicted set point scenarios based upon the initial set points and the predicted degradation factors;
   executing, by the electrolysis prediction processing hardware, an AI operator assistant engine, wherein executing the AI operator assistant engine comprises:
      predicting a selected set point configuration based upon weighting process characteristics received from an operator and the predicted set point scenarios; and
   performing, by the automated electrolysis system, an electrolysis process in accordance with the selected set point configuration.
Clause 7. The method of Clause 6, further comprising:
   receiving, after configuring the automated electrolysis system, process measurement information from the electrolysis monitoring sensors;
   executing, by the electrolysis prediction processing hardware, an AI observer engine, wherein executing the AI observer engine comprises:
      modeling a predicted electrolysis process based upon the electrolysis measurement information and the selected set point configuration; and
      determining one or more performance trend differences based upon the predicted electrolysis process and the process measurement information;
   executing, by the electrolysis prediction processing hardware, an AI reasoning engine, wherein executing the AI reasoning engine comprises:
      modeling one or more updated set point scenarios based upon the performance trend differences and the electrolysis measurement information to generate identified scenarios causing the performance trend differences;
   executing, by the electrolysis prediction processing hardware, an AI error minimization engine, wherein executing the AI error minimization engine comprises:
      generating retraining information based upon the identified scenarios;
      training the AI electrolysis prediction engine with the retraining information.
Clause 8. The method of Clause 6, further comprising:
   receiving a configuration input from an electrolysis configuration software wherein the configuration input comprises a configuration status and configuration information.
Clause 9. The method of Clause 8, further comprising:
   transmitting, in response to the configuration status indicating a rejection of the selected set point configuration, the selected set point configuration to the electrolysis prediction processing hardware;
   executing, by the electrolysis prediction processing hardware, an AI reasoning engine, wherein executing the AI reasoning engine comprises:
      receiving the configuration information; and
      modeling one or more updated set point scenarios based upon the configuration information and the electrolysis measurement information to generate identified scenarios related to the configuration status indicating a rejection of the selected set point configuration;
   executing, by the electrolysis prediction processing hardware, an AI error minimization engine, wherein executing the AI error minimization engine comprises:
      generating retraining information based upon the identified scenarios; and
      training the AI electrolysis prediction engine with the retraining information;
   executing the AI electrolysis prediction engine based on the retraining information to update the predicted set point scenarios; and
   executing the AI operator assistant engine based on the updated predicted set point scenarios to update the selected set point configuration.
Clause 10. The method of Clause 6, wherein the electrolysis measurement information comprises at least one of a stack current measurement, an electrolyte concentration measurement, a stack temperature measurement, or an inlet pressure measurement.
Clause 11. The method of Clause 6, wherein the automated electrolysis system is configured to perform electrolysis through one of the group of anion exchange membrane electrolysis, proton exchange membrane electrolysis, alkaline electrolysis, and solid oxide electrolyzer cells.
Clause 12. The method of Clause 6, further comprising:
   measuring, by the electrolysis monitoring sensors, an electrolysis operation of the automated electrolysis system generating process measurement information;
   executing, by the electrolysis prediction processing hardware, the artificial intelligence (AI) electrolysis prediction engine, wherein executing the AI electrolysis engine further comprises:
      modeling, by the first principles model, one or more updated initial set points based upon the process measurement information;
      modeling, by the machine learning models, one or more updated predicted degradation factors based upon the process measurement information; and
      generating one or more updated predicted set point scenarios based upon the updated initial set points and the updated predicted degradation factors;
   executing, by the electrolysis prediction processing hardware, an AI operator assistant engine, wherein executing the AI operator assistant engine comprises:
      receiving, from the AI electrolysis prediction engine, the updated predicted set point scenarios;
      predicting an updated selected set point configuration based upon weighting the process characteristics and the updated predicted set point scenarios; and
   configuring, by an electrolysis management processor, an automated electrolysis system with the updated selected set point configuration.
Clause 13. The method of Clause 6, wherein the predicted degradation factors comprise at least one of electrolyzer degradation or electro-osmatic drag.
Clause 14. The method of Clause 6, wherein the process characteristics comprise at least one of an electrolyzer lifespan target or an electrolysis efficiency target.
Clause 15. The method of Clause 6, wherein generating one or more predicted set point scenarios is further based upon a measured a measured concentration of an electrolyte and a measured pH of the electrolyte.
Clause 16. A method of training an artificial intelligence (AI) electrolysis prediction engine, comprising:
   collecting, from an automated electrolysis system, historical electrolysis process information, historical concentration information, and historical electrolysis measurement information;
   training an electrolyzer degradation sensor machine learning model based upon the historical concentration information and historical electrolysis process information;
   training an electro-osmatic drag machine learning model based upon the historical electrolysis measurement information;
   executing, by an electrolysis prediction processor, an AI error minimization engine to generate retraining information wherein executing the AI error minimization engine comprises:
      retrieving electrolysis process information from an electrolysis process database;
      generating, by a machine learning model, retraining information based upon the electrolysis process information;
   retraining at least one of the electrolyzer degradation sensor machine learning model or the electro-osmatic drag machine learning model with the retraining information.
Clause 17. The method of Clause 16, wherein retraining at least one of the electrolyzer degradation sensor machine learning model or the electro-osmatic drag machine learning model with the retraining information comprises updating at least one weight of the at least one of the electrolyzer degradation sensor machine learning model or the electro-osmatic drag machine learning model.
Clause 18. The method of Clause 16, wherein the historical concentration information comprises at least one of operational hours, non-operational hours, one or more voltage changes, a number of ramp up cycles, or operating conditions information.
Clause 19. The method of Clause 16, wherein the historical electrolysis measurement information comprises at least one of a stack temperature, a cathode pressure, a current density, a water inlet flow, a water level in a H₂/H₂O separator, and a water level in a O₂/H₂O separator.
Clause 20. The method of Clause 16, wherein the electrolysis process information comprises at least one of a stack current measurement, an electrolyte concentration measurement, a stack temperature measurement, or an inlet pressure measurement measured during execution of an electrolysis process using a predicted set point configuration.

## Claims

1. A green hydrogen production system comprising:
an automated electrolysis system (102) configured to perform electrolysis in response to an input set point configuration;
an automation control processor (106) communicatively coupled to the automated electrolysis system (102), the automation control processor (106) being configured to receive the input set point configuration and configure the automated electrolysis system (102) with the input set point configuration;
one or more electrolysis monitoring sensors (104) coupled to the automated electrolysis system (102), the one or more electrolysis monitoring sensors (104) being configured to measure one or more process indicators to generate electrolysis measurement information;
electrolysis prediction processing hardware coupled to the one or more electrolysis monitoring sensors (104);
a memory coupled to the electrolysis prediction processing hardware, the memory storing computer-executable instructions that, when executed by the electrolysis prediction processing hardware, configure the green hydrogen production system for:
receiving, from the one or more electrolysis monitoring sensors (104), the electrolysis measurement information;
executing an artificial intelligence, AI, electrolysis prediction engine (112) to predict one or more set point scenarios, wherein executing the AI electrolysis prediction engine (112) comprises:
generating, by a first principles model, one or more initial set points based upon the received electrolysis measurement information;
modeling, by one or more machine learning models, one or more predicted degradation factors based upon the received electrolysis measurement information; and
generating the one or more predicted set point scenarios based upon the initial set points and the predicted degradation factors;
executing an AI operator assistant engine (110) to determine selected set points, wherein executing the AI operator assistant engine (110) comprises:
predicting a selected set point configuration based upon weighting process characteristics received from an operator and the predicted set point scenarios; and
transmitting the selected set point configuration to the automation control processor (106) as the input set point configuration.

2. The system of claim 1, wherein the memory stores computer-executable instructions that, when executed by the electrolysis prediction processing hardware, configure the green hydrogen production system for:
executing, after transmitting the selected set point configuration, an AI observer engine (114) to determine one or more performance trend differences, wherein executing the AI observer engine (114) comprises:
modeling a predicted electrolysis process based upon the electrolysis measurement information and the selected set point configuration;
receiving process measurement information from the one or more electrolysis monitoring sensors (114), wherein the one or more electrolysis sensors (114) are configured to measure the process indicators during execution of an electrolysis process for generating the process measurement information; and
determining the performance trend differences based upon the predicted electrolysis process and the process measurement information;
executing an AI reasoning engine (116) to predict identify scenarios causing the performance trend differences, wherein executing the AI observer engine (114) comprises:
modeling one or more updated set point scenarios based upon the performance trend differences and the electrolysis measurement information to generate identified scenarios causing the performance trend differences; and
executing an AI error minimization engine (118) to generate retraining information, wherein executing the AI error minimization engine (118) comprises:
generating retraining information based upon identified scenarios; and
training the AI electrolysis prediction engine (112) with the retraining information.

3. The system of claim 1 or claim 2, wherein each of the process indicators comprises at least one of a stack current measurement, an electrolyte concentration measurement, a stack temperature measurement, or an inlet pressure measurement.

4. The system of any of claims 1 to 3, wherein the automated electrolysis system (102) is configured to perform electrolysis using one of the group of anion exchange membrane electrolysis, proton exchange membrane electrolysis, alkaline electrolysis, and solid oxide electrolyzer cells.

5. The system of any of claims 1 to 4, comprising a memory coupled to the automation control processor (106), the memory coupled to the automation control processor (106) storing computer-executable instructions that, when executed by the electrolysis prediction processing hardware, configure the green hydrogen production system for:
receiving the selected set point configuration;
transmitting, to a display coupled to the automation control processor (106), the selected set point configuration;
receiving, from an input device, a configuration status and a configuration rejection reasoning;
transmitting, in response to the configuration status indicating rejection of the selected set point configuration, the configuration rejection reasoning to the AI reasoning engine (116); and
executing, in response to the configuration status indicating acceptance of the selected set point configuration, an electrolysis process on the automated electrolysis system (102) in accordance with the selected set point configuration.

6. A method for producing green hydrogen, the method comprising:
collecting (316) electrolysis measurement information from one or more electrolysis monitoring sensors (104) of an automated electrolysis system (102);
executing, by electrolysis prediction processing hardware, an artificial intelligence, AI, electrolysis prediction engine (112), wherein executing the AI electrolysis prediction engine comprises (112):
generating (318), by a first principles model (304), one or more initial set points based upon the electrolysis measurement information;
modeling (320), by one or more machine learning models, one or more predicted degradation factors based upon the electrolysis measurement information; and
generating (322) one or more predicted set point scenarios based upon the initial set points and the predicted degradation factors;
executing, by the electrolysis prediction processing hardware, an AI operator assistant engine (110), wherein executing the AI operator assistant engine (110) comprises:
predicting a selected set point configuration based upon weighting process characteristics received from an operator and the predicted set point scenarios; and
performing (330), by the automated electrolysis system (102), an electrolysis process in accordance with the selected set point configuration.

7. The method of claim 6, comprising:
receiving, after configuring the automated electrolysis system (102), process measurement information from the one or more electrolysis monitoring sensors (104);
executing, by the electrolysis prediction processing hardware, an AI observer engine (114), wherein executing the AI observer engine (114) comprises:
modeling a predicted electrolysis process based upon the electrolysis measurement information and the selected set point configuration; and
determining one or more performance trend differences based upon the predicted electrolysis process and the process measurement information;
executing, by the electrolysis prediction processing hardware, an AI reasoning engine (116), wherein executing the AI reasoning engine (116) comprises:
modeling one or more updated set point scenarios based upon the performance trend differences and the electrolysis measurement information to generate identified scenarios causing the performance trend differences;
executing, by the electrolysis prediction processing hardware, an AI error minimization engine (118), wherein executing the AI error minimization engine (118) comprises:
generating retraining information based upon the identified scenarios;
training the AI electrolysis prediction engine (112) with the retraining information.

8. The method of claim 6 or claim 7, comprising:
receiving a configuration input from an electrolysis configuration software, wherein the configuration input comprises a configuration status and configuration information.

9. The method of claim 8, comprising:
transmitting, in response to the configuration status indicating a rejection of the selected set point configuration, the selected set point configuration to the electrolysis prediction processing hardware;
executing, by the electrolysis prediction processing hardware, an AI reasoning engine (116), wherein executing the AI reasoning engine (116) comprises:
receiving the configuration information; and
modeling one or more updated set point scenarios based upon the configuration information and the electrolysis measurement information to generate identified scenarios related to the configuration status indicating a rejection of the selected set point configuration;
executing, by the electrolysis prediction processing hardware, an AI error minimization engine (118), wherein executing the AI error minimization engine (118) comprises:
generating retraining information based upon the identified scenarios; and
training the AI electrolysis prediction engine (112) with the retraining information;
executing the AI electrolysis prediction engine (112) based on the retraining information to update the predicted set point scenarios; and
executing the AI operator assistant engine (110) based on the updated predicted set point scenarios to update the selected set point configuration.

10. The method of any of claims 6 to 9, comprising:
measuring, by the one or more electrolysis monitoring sensors (104), an electrolysis operation of the automated electrolysis system (102) generating process measurement information;
executing, by the electrolysis prediction processing hardware, the AI electrolysis prediction engine (112), wherein executing the AI electrolysis prediction engine (112) comprises:
modeling, by the first principles model (304), one or more updated initial set points based upon the process measurement information;
modeling, by the machine learning models, one or more updated predicted degradation factors based upon the process measurement information; and
generating one or more updated predicted set point scenarios based upon the updated initial set points and the updated predicted degradation factors;
executing, by the electrolysis prediction processing hardware, an AI operator assistant engine (110), wherein executing the AI operator assistant engine (110) comprises:
receiving, from the AI electrolysis prediction engine (112), the updated predicted set point scenarios;
predicting an updated selected set point configuration based upon weighting the process characteristics and the updated predicted set point scenarios; and
configuring, by an electrolysis management processor, an automated electrolysis system (102) with the updated selected set point configuration.

11. The method of any of claims 6 to 10, wherein at least one of:
the predicted degradation factors comprise at least one of electrolyzer degradation or electro-osmatic drag;
the process characteristics comprise at least one of an electrolyzer lifespan target or an electrolysis efficiency target; or
generating one or more predicted set point scenarios is further based upon a measured a measured concentration of an electrolyte and a measured pH of the electrolyte.

12. A method of training an artificial intelligence, AI, electrolysis prediction engine (112), the method comprising:
collecting, from an automated electrolysis system (102), historical electrolysis process information, historical concentration information, and historical electrolysis measurement information;
training an electrolyzer degradation sensor machine learning model (308) based upon the historical concentration information and historical electrolysis process information;
training an electro-osmatic drag machine learning model (310) based upon the historical electrolysis measurement information;
executing, by an electrolysis prediction processor, an AI error minimization engine (118) to generate retraining information wherein executing the AI error minimization engine (118) comprises:
retrieving electrolysis process information from an electrolysis process database (108);
generating, by a machine learning model, retraining information based upon the electrolysis process information;
retraining at least one of the electrolyzer degradation sensor machine learning model (308) or the electro-osmatic drag machine learning model (310) with the retraining information.

13. The method of claim 12, wherein retraining at least one of the electrolyzer degradation sensor machine learning model (308) or the electro-osmatic drag machine learning model (310) with the retraining information comprises updating at least one weight of the at least one of the electrolyzer degradation sensor machine learning model (308) or the electro-osmatic drag machine learning model (310).

14. The method of claim 12 or claim 13, wherein at least one of:
the historical concentration information comprises at least one of operational hours, non-operational hours, one or more voltage changes, a number of ramp up cycles, or operating conditions information; or
the historical electrolysis measurement information comprises at least one of a stack temperature, a cathode pressure, a current density, a water inlet flow, a water level in a H₂/H₂O separator, and a water level in a O₂/H₂O separator.

15. The method of any of claims 12 to 14, wherein the electrolysis process information comprises at least one of a stack current measurement, an electrolyte concentration measurement, a stack temperature measurement, or an inlet pressure measurement measured during execution of an electrolysis process using a predicted set point configuration.
